# EUROPEAN PATENT APPLICATION

(11) **EP 2 023 207 A1**
(43) Date of publication of application: **11.02.2009**
(21) Application number: 08162112.0
(22) Date of filing: 08.08.2008
(51) Int. Cl.: G03F 7/20

(54) **Exposure apparatus and device manufacturing method**

(30) Priority: 10.08.2007 JP 2007210294; 30.07.2008 JP 2008196805
(71) Applicant: Canon Kabushiki Kaisha, Tokyo 146-8501 (JP)
(72) Inventor: Yoshida, Tomohiko, Ohta-ku Tokyo (JP)
(74) Representative: Sharp, Alan Cooper

(57) **Abstract**

An exposure apparatus projects a pattern of an original (1) onto a substrate (9) through a projection optical system (4) and a liquid (f) and thereby exposes the substrate (9). The exposure apparatus includes a supply unit (30) that supplies the liquid to a space under the projection optical system (4), a suction unit (50) that sucks a fluid in the space under the projection optical system (4), and a fluid sensor (23) that detects the change in kind of the fluid being sucked by the suction unit (50). The operating state of the suction unit (50) is changed in response to the fluid sensor's detection of the change in kind of the fluid being sucked by the suction unit (50).

## Description

### BACKGROUND OF THE INVENTION

### Field of the Invention

The present invention relates to an exposure apparatus that projects a pattern of an original onto a substrate through a projection optical system and a liquid and thereby exposes the substrate, and a device manufacturing method for manufacturing devices using the exposure apparatus.

### Description of the Related Art

During the process of manufacturing semiconductor devices having an extremely fine pattern, such as LSIs, a reduction projection exposure apparatus is used, which reduces, projects, and transfers a pattern of an original onto a substrate coated with photoresist. Along with the improvement in the integration density of semiconductor devices, further miniaturization of a pattern to be transferred onto a substrate is required. The resist process has been developed and exposure apparatuses have coped with miniaturization.

Typical methods for improving the resolving power of an exposure apparatus include shortening the exposure wavelength and increasing the numerical aperture (NA) of the projection optical system. The exposure wavelength is being shifted from i-line of 365 nm to ArF excimer laser light having a wavelength of about 193 nm. In addition, a fluorine (F2) excimer laser having a wavelength of about 157 nm is also under development.

As a resolving-power improving technique completely different from these, a projection exposure method using an immersion method has attracted attention. Conventionally, the space between the undersurface of the projection optical system and the substrate surface has been filled with gas. In the immersion method, this space is filled with liquid to expose the substrate through the liquid. For example, assume that the liquid provided to the space between the projection optical system and the substrate is pure water (refractive index 1.33). If the maximum incidence angle of light rays that form an image on the substrate in the immersion method is equal to that in the conventional method, the resolving power of the immersion method is 1.33 times that of the conventional method even when light sources of the same wavelength are used. This is equivalent to increasing the NA of the projection optical system of the conventional method by 1.33 times. The immersion method makes it possible to obtain a high resolving power, an NA of one or more, which cannot be attained by the conventional method.

Methods for filling the space between the undersurface of the projection optical system and the substrate surface with liquid include a local fill method, in which only the space between the undersurface of the projection optical system and the substrate surface is filled with liquid. This is disclosed in Japanese Patent Laid-Open Nos. 2005-19864 and 2005-101488.

WO 2005-081292 discloses determining the formation of a liquid film from the time elapsed since the start of liquid supply or by comparing the flow rate of the liquid supplied with the flow rate of the liquid recovered.

Japanese Patent Laid-Open Nos. 2005-19864 and 2005-101488 disclose neither any means for confirming that the space under the projection optical system has been filled with liquid to start to expose the substrate, nor any means for confirming that liquid has been removed from the space under the projection optical system after the completion of exposure of the entire shot region of the substrate.

Although WO 2005-081292 discloses comparing the supply flow rate with the recovery flow rate, this is only for confirming that the structures for supplying and recovering liquid are functioning. In addition, to measure the recovery flow rate, it will be necessary, for example, to extract liquid from gas-liquid mixture using a gas-liquid separator and measure the flow rate thereof. It is difficult to locate a gas-liquid separator near the projection optical system. Therefore, a gas-liquid separator and a flow meter are disposed apart from the recovery port. This delays the detection of flow rate by the flow meter.

### SUMMARY OF THE INVENTION

The present invention is directed to reliably performing control of liquid (for example, formation or removal of a liquid film) in the space under the projection optical system.

The present invention in its first aspect provides an exposure apparatus as specified in claims 1 to 10.

The present invention in its second aspect provides a device manufacturing method as specified in claim 11.

Further features of the present invention will become apparent from the following description of exemplary embodiments with reference to the attached drawings.

### BRIEF DESCRIPTION OF THE DRAWINGS

FIG. 1 is a schematic view showing the structure of an exposure apparatus according to an embodiment of the present invention.

FIGS. 2A to 2D illustrate the procedure for forming a liquid film (liquid) in the space between the projection optical system and the substrate.

FIGS. 3A to 3C illustrate the procedure for removing a liquid film (liquid) from the space under the projection optical system.

FIG. 4 shows another embodiment of the present invention.

FIG. 5 shows another embodiment of the present invention.

FIG. 6 shows a device manufacturing method.

FIG. 7 shows a device manufacturing method.

### DESCRIPTION OF THE EMBODIMENTS

The exposure apparatus of the present invention projects a pattern of an original (reticle) onto a substrate (for example, a wafer) through a projection optical system and a liquid, thereby exposing the substrate. The term "substrate" means a substrate coated with photoresist, unless it is contrary to the common general knowledge in the art. Ultraviolet light can be used as exposure light for exposing the substrate. The exposure apparatus can be an exposure apparatus that exposes a stationary substrate (so-called stepper) or an exposure apparatus that exposes a substrate while synchronously scanning the substrate and an original (so-called scanner).

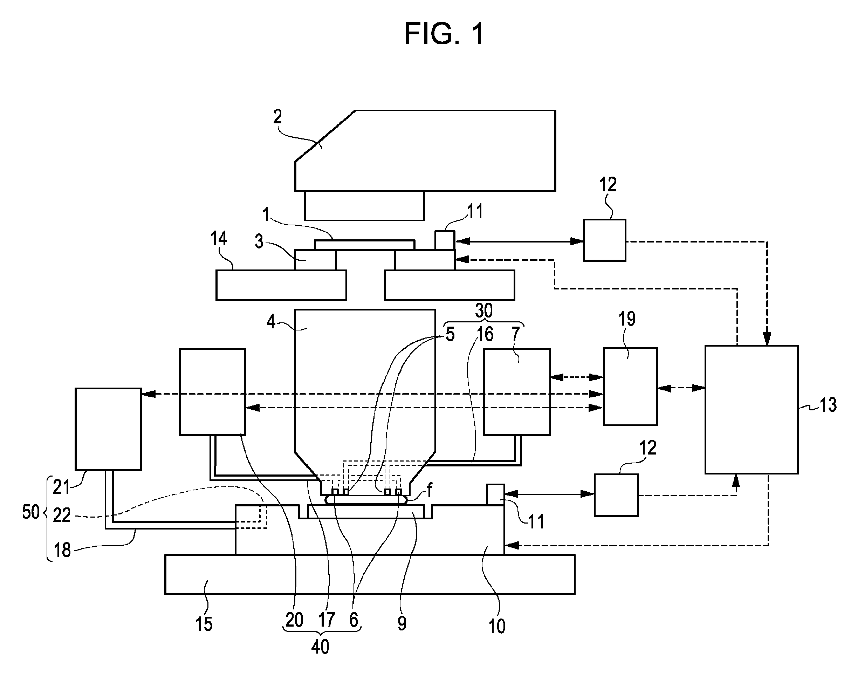

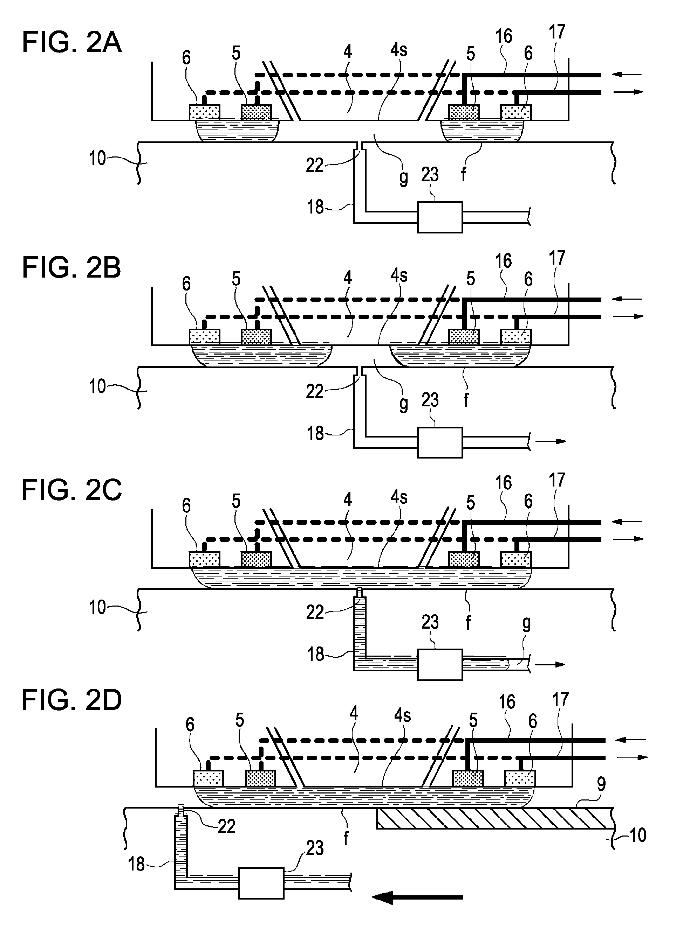

FIG. 1 is a schematic view showing the structure of an exposure apparatus according to an embodiment of the present invention. FIGS. 2A to 2D show part of FIG. 1 in detail. This exposure apparatus is a scanner (scanning exposure apparatus). In FIG. 1, light emitted from a light source (not shown) such as an ArF excimer laser or an F2 laser is provided to an illumination optical system 2. Using the light provided from the light source, the illumination optical system 2 illuminates part of an original (reticle) 1 with a slit light beam (a light beam whose cross-sectional shape is defined by a slit). While the original 1 is illuminated with the slit light beam, an original stage (reticle stage) 3 holding the original 1 and a substrate stage (wafer stage) 10 holding the substrate (wafer) 9 are scanned synchronously. By such synchronous scanning, the entire pattern of the original 1 is transferred onto the substrate 9 through a projection optical system 4 and liquid.

The original stage 3 is supported by a base 14. The substrate stage 10 is supported by a base 15. The two-dimensional positions of the original stage 3 and the substrate stage 10 are measured in real time by measuring devices including reference mirrors 11 and laser interferometers 12. On the basis of the measurements, a stage control unit 13 performs positioning and synchronous control of the original 1 (original stage 3) and the substrate 9 (substrate stage 10). The substrate stage 10 is driven by a drive mechanism, and thereby the position in the vertical direction, the rotational direction, and the inclination of the substrate 9 can be controlled. During exposure, the substrate stage 10 can be controlled by this drive mechanism so that the surface of the substrate 9 corresponds to the focal plane of the projection optical system 4. The position (the position in the vertical direction and the inclination) of the surface of the substrate 9 is measured by an optical focus sensor (not shown) and is provided to the stage control unit 13.

A main body of the exposure apparatus is installed in an environmental chamber (not shown), and the environment around the main body can be maintained at a predetermined temperature. Individually temperature-controlled air streams are blown into the space surrounding the original stage 3, the substrate stage 10, and the laser interferometer 12 and the space surrounding the projection optical system 4. The environmental temperature can be thereby maintained with a high degree of accuracy.

The exposure apparatus includes a supply unit 30 that supplies liquid to the space under the projection optical system 4, and a recovery unit 40 that recovers liquid from the space under the projection optical system 4. The space between the projection optical system 4 and the substrate 9 is filled with liquid. At least during the exposure of the substrate 9, the supply of liquid by the supply unit 30 and the recovery of liquid by the recovery unit 40 can be performed. The exposure apparatus further includes a suction unit 50 that sucks fluid in the space under the undersurface 4s of the projection optical system 4, and a fluid sensor 23 that detects a change in the kind of fluid being sucked by the suction unit 50. When the fluid sensor 23 detects the change in kind of fluid being sucked by the suction unit 50, the operating state of the suction unit 50 is changed accordingly.

The supply unit 30 can include a supply nozzle 5 disposed over the substrate 9 and around the projection optical system 4, a supply tube 16 connected to the supply nozzle 5, and a supply device 7 that supplies liquid to the supply tube 16. The recovery unit 40 can include a recovery nozzle 6 disposed outside the supply nozzle 5, a recovery tube 17 connected to the recovery nozzle 6, and a recovery device 20 that recovers liquid through the recovery tube 17. The suction unit 50 can include, for example, a suction port 22 disposed in the substrate stage 10, a suction tube 18 connected to the suction port 22, and a suction device 21 that sucks fluid (gas and/or liquid) through the suction tube 18.

The supply device 7 can include a tank that stores liquid, a pump that pumps out liquid, and a flow rate controller that controls the flow rate of liquid being supplied. The supply device 7 desirably further includes a temperature controller for controlling the temperature of the liquid to be supplied. The recovery device 20 can include, for example, a tank that temporarily stores liquid recovered, a pump that sucks liquid, and a flow rate controller that controls the flow rate of liquid being recovered. The suction device 21 can include, for example, a tank that temporarily stores liquid sucked, and a pump that sucks fluid.

A control unit 19 receives information showing the position, velocity, acceleration, moving direction, and so forth of the substrate stage 10 from the stage control unit 13, and receives information showing the change in kind of fluid being sucked by the suction unit 50 from the fluid sensor 23. The control unit 19 controls, on the basis of the information received, the operation of the supply unit 30, the recovery unit 40, and the suction unit 50.

Liquid for immersion desirably has a reduced propensity to absorb exposure light, and more desirably has a refractive index comparable to those of refractive optical elements such as quartz and fluorite. Specifically, desirable liquids for immersion include pure water, functional water, and fluorinated liquid (for example, fluorocarbon). Dissolved gases are desirably sufficiently removed from the liquid for immersion using a degasifier in advance. The reason is that generation of gas bubbles is suppressed and even if gas bubbles are generated, they can be immediately absorbed in liquid. For example, if nitrogen and oxygen, which are contained in a large quantity in the environmental gas, are removed from liquid by 80% or more of the gas quantity dissolvable in liquid, generation of gas bubbles can be sufficiently suppressed. Of course, liquid may be supplied to the supply device 7 while dissolved gases in liquid are removed using a not shown degasifier provided in the exposure apparatus. For example, a vacuum degasifier is suitable as a degasifier. A vacuum degasifier makes liquid flow on one side of a gas-permeable film, forms a vacuum on the other side, and expels dissolved gases in liquid into the vacuum through the film.

Next, with reference to FIGS. 2A to 2D, the procedure for forming a liquid film (liquid) in the space between the projection optical system 4 and the substrate 9 will be described. First, the stage control unit 13 moves the substrate stage 10 so that the suction port 22 is positioned just below substantially the center of the region occupied by the annular supply nozzle 5 disposed around the periphery of the undersurface (the final surface) 4s of the projection optical system 4. In this state, liquid f is supplied from the whole circumference of the annular supply nozzle 5 onto the substrate stage 10 (FIG. 2A). Liquid f supplied onto the substrate stage 10 takes the form of a ring along the arrangement of the supply nozzle 5. Gas g remains inside that and between the undersurface 4s of the projection optical system 4 and the substrate stage 10. If liquid simply continues to be supplied from the supply nozzle 5, gas g remains trapped inside the liquid film f. Therefore, the space under the undersurface 4s of the projection optical system 4 is never completely filled with liquid.

Therefore, gas g is sucked out of the space under the undersurface 4s of the projection optical system 4 (the space between the undersurface 4s and the substrate stage 10) through the suction port 22 by the suction unit 50 with the space annularly supplied with liquid f from the supply nozzle 5. This suction makes the pressure in the part where gas g exists lower than the pressure of the external environment, and an inward force (a force toward the suction port 22) acts on the annular liquid film f therearound. Therefore, the liquid film f begins to spread rapidly toward the suction port 22 (FIG. 2B).

Continued suction by the suction unit 50 through the suction port 22 causes the space under the undersurface 4s of the projection optical system 4 (the space between the undersurface 4s and the substrate stage 10) to be filled with liquid. Replacing gas, liquid passes through the fluid sensor 23 disposed at the middle of the suction tube 18. At this time, the fluid sensor 23 detects the change in kind of fluid being sucked through the suction tube 18 by the suction unit 50 from gas to liquid. When the change in kind of fluid being sucked through the suction tube 18 from gas to liquid is detected, the space between the undersurface 4s of the projection optical system 4 and the substrate stage 10 does not contain a mixture of gas and liquid, but is filled with liquid f only (FIG. 2C).

When the change in kind of fluid being sucked through the suction tube 18 from gas to liquid is detected by the fluid sensor 23, the control unit 19 changes the operating state of the suction unit 50 accordingly. The change of the operating state includes, for example, stopping the suction of fluid, or reducing the quantity of suction. When the change in kind of fluid being sucked through the suction tube 18 from gas to liquid is detected by the fluid sensor 23, the operating state of the suction unit 50 may be changed immediately in response to the detection. However, for the sake of reliability, the operating state of the suction unit 50 may be changed a predetermined time after the detected change.

During the steps of FIGS. 2A to 2C, the operation of the recovery unit 40 may be stopped. However, the recovery unit 40 may operate to prevent liquid from spattering out due to vibration or sudden change in the quantity of liquid supplied.

While the substrate stage 10 is stopped, supply from the supply nozzles 5 may be stopped. However, when liquid is stationary, gases and impurities constituting the ambient environment can be constantly taken into the liquid. Due to increased density of gas bubbles and impurities, gas bubbles generated can remain even after the start of the exposure, minute gas bubbles can be generated by the exposure, and impurities taken in can cloud the undersurface 4s of the projection optical system 4. To avoid such problems, it is desirable to continue to supply liquid from the supply unit 30 even while the substrate stage 10 is stopped, and to recover liquid at least with the recovery unit 40 while the liquid is supplied.

Finally, the stage control unit 13 moves the substrate stage 10 so that the region of the substrate 9 to be exposed is located under the undersurface 4s of the projection optical system 4 with the liquid supply by the supply unit 30 and the liquid recovery by the recovery unit 40 continued (FIG. 2D). Thus, liquid f is disposed in the space between the undersurface 4s of the projection optical system 4 and the substrate 9. Next, the entire shot region of the substrate 9 is exposed by the step and scan method.

Growing the annular liquid film toward the center by sucking gas with the suction unit 50 can form a liquid film free from gas bubbles more quickly. By detecting the change in kind of fluid flowing through the suction tube 18 from gas to liquid with the fluid sensor 23 disposed in the suction tube 18, completion of formation of a liquid film can be confirmed reliably and in a short time. Thus, the throughput of the exposure apparatus can be improved.

For example, a capacitive fluid sensor can be used as the fluid sensor 23. However, it is desirable to use an optical sensor using the difference in refractive index between liquid and gas. An optical sensor can be installed outside a transparent tube. Particularly in the case of a thin tube of 3/4 inch or less in diameter, a laminar flow in which liquid and gas are separated does not occur and only liquid or only gas flows through the tube, and therefore the kind of fluid is easily represented by on/off signals. When a capacitive fluid sensor is used, the kind of fluid can be determined based on a predetermined threshold using the fact that the flow rate is high when a gas-laden fluid is sucked and the flow rate is low when a liquid-laden fluid is sucked. However, since detection of flow rate is influenced by the length of tube and pressure drop, the longer the distance from the recovery nozzle 6 to the recovery device 20, the more disadvantageous.

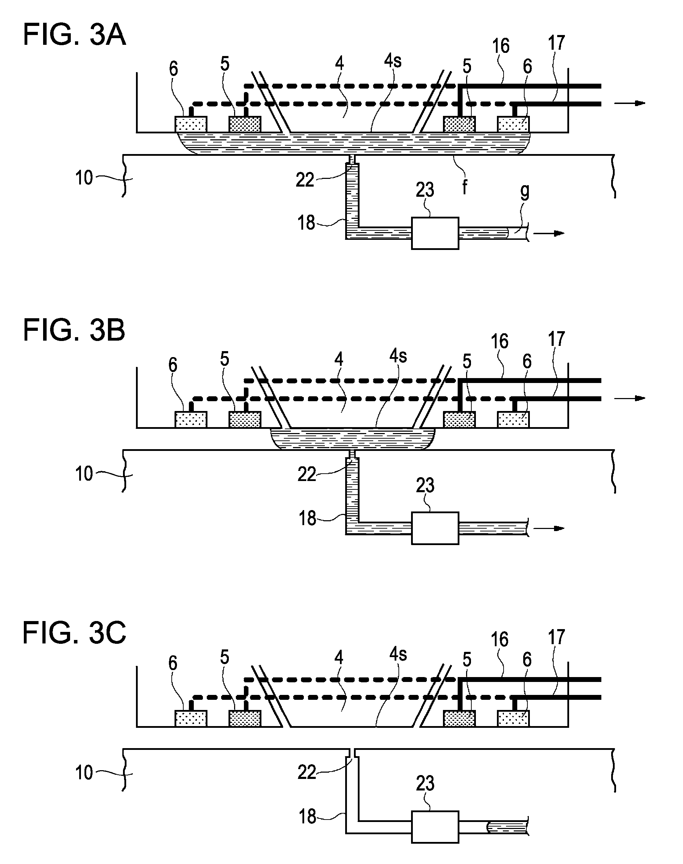

Next, with reference to FIGS. 3A to 3C, the procedure for removing the liquid film (liquid) from the space under the undersurface 4s of the projection optical system 4 after completion of exposure of the entire shot region of the substrate 9 will be described. First, the stage control unit 13 moves the substrate stage 10 so that the suction port 22 is positioned just below substantially the center of the region occupied by the annular supply nozzle 5 disposed around the periphery of the undersurface (the final surface) 4s of the projection optical system 4. In this state, the control unit 19 stops the liquid supply onto the substrate stage 10 by the supply unit 30 (FIG. 3A).

Next, the liquid (liquid film) f existing between the undersurface 4s of the projection optical system 4 and the substrate stage 10 is sucked through the suction port 22 by the suction unit 50 (FIG. 3B). Continued suction completely removes the liquid f under the undersurface 4s of the projection optical system 4. Replacing liquid, gas is sucked through the suction port 22 (FIG. 3C). Thus, replacing liquid, gas passes through the fluid sensor 23 disposed at the middle of the suction tube 18. At this time, the fluid sensor 23 detects the change in the kind of fluid being sucked through the suction tube 18 by the suction unit 50 from liquid to gas. When this change is detected, the liquid f is completely removed from the space between the undersurface 4s of the projection optical system 4 and the substrate stage 10.

When the change in the kind of fluid being sucked through the suction tube 18 by the suction unit 50 from liquid to gas is detected by the fluid sensor 23, the control unit 19 changes the operating state of the suction unit 50 accordingly. The change in operating state is typically stopping the suction of fluid. However, in the process of sucking the liquid film f through the suction port 22, there are generally differences in wettability among the undersurface 4s of the projection optical system 4, the supply nozzle 5, the recovery nozzle 6, and the wetted surface of the substrate stage 10. Therefore, in the process of sucking the liquid film f through the suction port 22, it is possible that contraction (recovery) of liquid does not progress concentrically around the suction port 22. This can cause a short path in which gas is sucked together with liquid. A short path slows down the speed at which liquid is sucked, and the suction unit 50 sucks mainly gas. In this case, the quantity of liquid flowing into the suction tube 18 is so small that the fluid sensor 23 can determine that the kind of fluid being sucked has changed from liquid to gas. Therefore, in the process of removing the liquid film, it is desirable to change the operating state of the suction unit 50 a predetermined time after the fluid sensor 23 detects the change in kind of fluid from liquid to gas. When the suction by the suction unit 50 is stopped, the recovery by the recovery unit 40 may also be stopped.

The above-described embodiment of the present invention can reliably detect that the space under the undersurface of the projection optical system has been filled with liquid and a liquid film has been formed, and can complete the liquid-film forming process in a shorter time. Therefore, the throughput of the exposure apparatus can be improved. In addition, defect exposure due to an incomplete liquid film can be prevented. In the process of removing the liquid in the space under the undersurface of the projection optical system, it can be reliably detected that the liquid has been removed from the space. Therefore, the substrate stage 10 can be prevented from being moved with liquid remaining thereon and spilling the liquid. Therefore, failure of the exposure apparatus can be prevented. In addition, the structure of the exposure apparatus can be simplified, and the size of the exposure apparatus can be reduced.

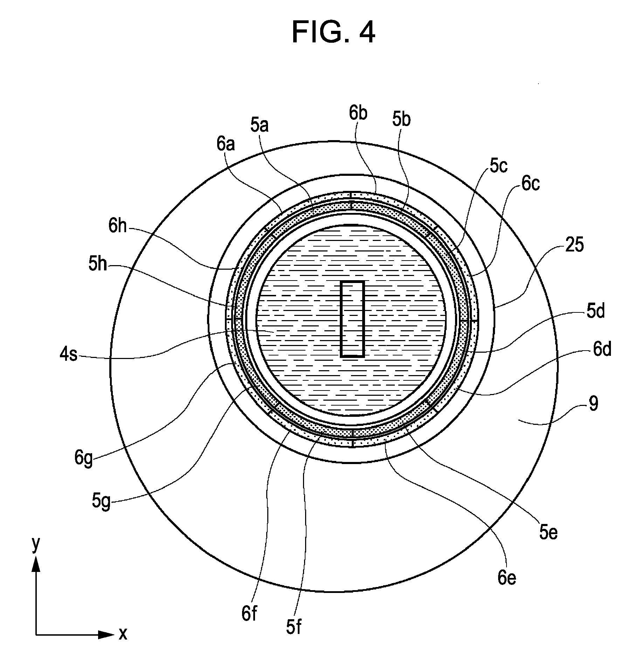

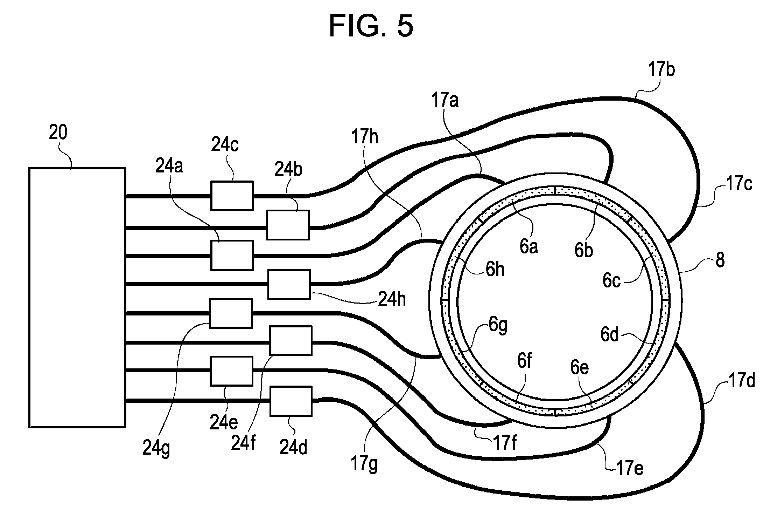

With reference to FIGS. 4 and 5, another embodiment will be described. As another embodiment, an example of the structure and arrangement of a supply nozzle 5, a recovery nozzle 6, and fluid sensors 24 will be provided. In this example, a recovery unit is used as a substitute for the suction unit. FIG. 4 is a plan view of the exposure apparatus of FIG. 1 cut at the lower part of the projection optical system. Around the undersurface 4s of the projection optical system 4 are disposed a supply nozzle 5 (5a to 5h), around which are disposed a recovery nozzle 6 (6a to 6h).

The supply nozzle 5 is desirably disposed in such a manner that the undersurface (lower end) thereof is level with or slightly higher than the undersurface 4s of the projection optical system 4. This inhibits gas from entering the undersurface 4s of the projection optical system 4 and enables the substrate to move with liquid sufficiently closely contact with the undersurface 4s. The recovery nozzle 6 is desirably disposed in such a manner that the undersurface (lower end) thereof is level with or slightly lower than the undersurface 4s of the projection optical system 4. This prevents liquid from being incompletely recovered. Therefore, liquid on the substrate can be recovered efficiently.

In the example shown in FIG. 4, the supply nozzle 5 is divided into eight supply nozzle segments 5a to 5h. Since the supply nozzle 5 is divided into a plurality of segments, supply nozzle segments that supply liquid can be switched according to the moving direction of the substrate stage 10. In addition, dividing the supply nozzle 5 into a plurality of segments is helpful in uniformly supplying liquid to a large region.

In the example shown in FIG. 4, the recovery nozzle 6 is also divided into eight recovery nozzle segments 6a to 6h. In the case where the recovery nozzle is not divided, if a liquid film is deformed due to viscosity of liquid and inertial force when the substrate stage 10 is moved, it is possible that a part of the recovery nozzle is in contact with liquid whereas another part of the recovery nozzle is in contact with gas. In this state, it is possible that the increased quantity of gas sucked lowers the sucking force (negative pressure) toward the recovery nozzle, part of liquid protrudes outside the recovery nozzle and even outside a contiguous member 25 around the recovery nozzle, and liquid remains on the substrate 9. By dividing the recovery nozzle 6 into a plurality of recovery nozzle segments 6a to 6h, it is possible to restrain the decrease in sucking force due to deformation of the liquid film and to prevent liquid from protruding and remaining. Recovery nozzle segments to be used may be selected according to the moving direction of the substrate stage 10.

FIG. 5 is a schematic view showing the recovery nozzle 6, recovery tubes 17, fluid sensors 24, and a recovery device 20. The recovery nozzles 6 is divided into eight recovery nozzle segments 6a to 6h. Recovery tubes 17a to 17h connected to the recovery nozzle segments 6a to 6h, respectively, are connected to the recovery device 20. The recovery device 20 desirably functions to control the recovery by the recovery tubes 17a to 17h individually. Fluid sensors 24a to 24h are provided in respective recovery tubes 17a to 17h. The fluid sensors 24a to 24h have the same function as the above-described fluid sensor 23.

Liquid can be removed from the space under the undersurface 4s of the projection optical system 4 by stopping the liquid supply from the supply nozzle segments 5a to 5h and sucking liquid through all or some of the recovery nozzle segments 6a to 6h. At this time, it is desirable to move the substrate stage 10 and thereby guide the liquid remaining between the undersurface 4s of the projection optical system 4 and the substrate 9 or the substrate stage 10 to recovery nozzle segments for suction.

Removal of the liquid film is confirmed on the basis of the output of the fluid sensors 24a to 24h. However, fluid is sucked in the state of gas-liquid mixture. Even when the change of fluid sucked from liquid to gas is detected by the fluid sensors, liquid may remain between the undersurface 4s of the projection optical system 4 and the substrate 9 or the substrate stage 10. Therefore, the suction may be continued for a predetermined time after the fluid sensor detects the change of fluid being sucked from liquid to gas.

If the outputs of all or some of the fluid sensors 24a to 24h indefinitely continue to show the detection of liquid, it is possible that there is a problem such as a failure or an abnormality. In this case, it is desirable to perform error processing such as user notification of a problem.

In the example of FIG. 5, every one of the recovery tubes 17a to 17h is provided with a fluid sensor. However, it is possible to join together a plurality of recovery tubes and provide the resultant recovery tube with a single fluid sensor. In the above-described embodiments, the operating state of the suction unit or the recovery unit is changed in response to the output of the fluid sensor or sensors. Alternatively or in addition, the operating state of the exposure apparatus may be changed. The operating state of the exposure apparatus includes, for example, formation of a liquid film, exposure of each shot of a substrate, removal of a liquid film, position measurement of each shot of a substrate, and movement for performing these operations, and is controlled by a control unit that controls the entire exposure apparatus.

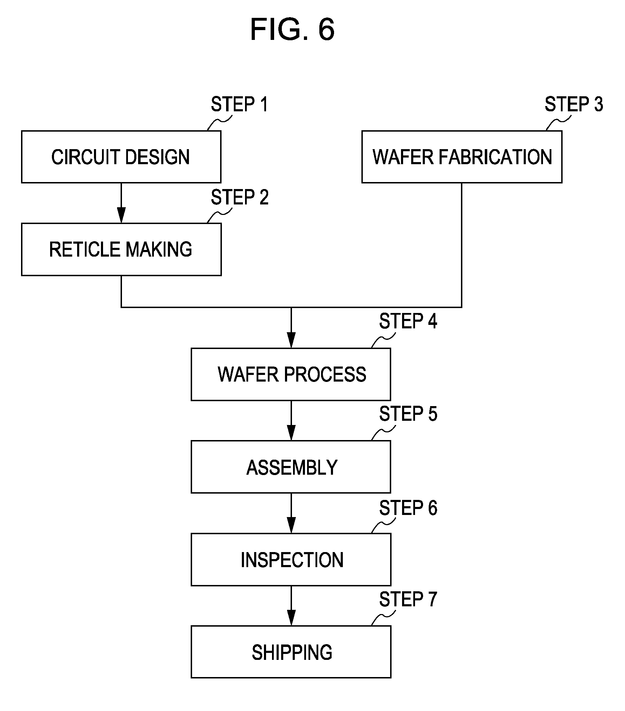

Next, a device manufacturing method using the above-described exposure apparatus will be described. FIG. 6 shows the overall flow of a semiconductor device manufacturing process. In step 1 (circuit design), a semiconductor device circuit is designed. In step 2 (reticle making), a reticle (also called an original or a mask) is made on the basis of the circuit pattern designed. In step 3 (wafer fabrication), wafers (also called substrates) are fabricated using a material such as silicon. In step 4 (wafer process), which is called a front-end process, actual circuits are formed on the wafers by lithography using the reticle, doping, oxidation, layer deposition and etching. In step 5 (assembly), which is called a back-end process, semiconductor chips are made from the wafers processed in step 4. Step 5 includes an assembly process (dicing and bonding) and a packaging process (chip encapsulation). In step 6 (inspection), inspections, such as an operation confirmation test and a durability test of the semiconductor devices made in step 5 are conducted. Through these processes, the semiconductor devices are completed, and shipped in step 7.

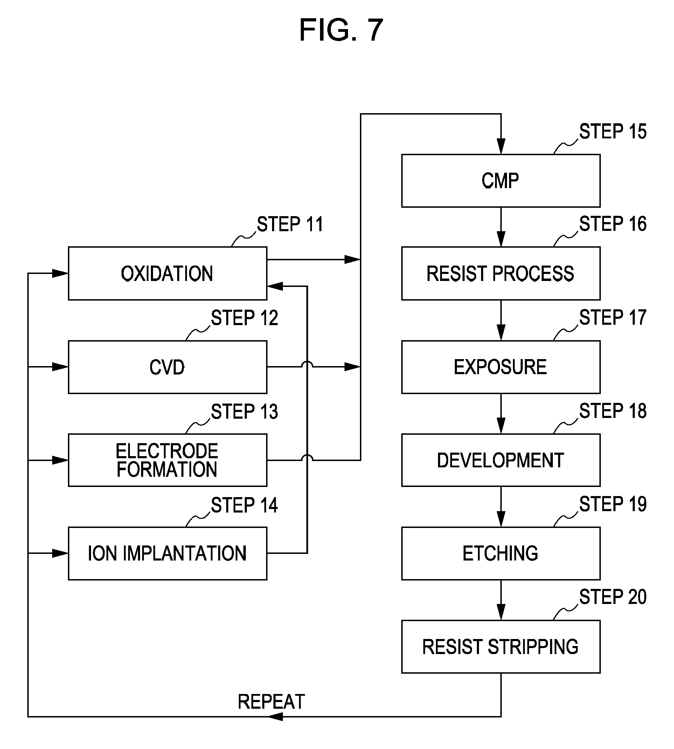

FIG. 7 illustrates a detailed flow of the wafer process. In step 11 (oxidation), the surface of a wafer is oxidized. In step 12 (CVD), an insulating film is formed on the wafer surface. In step 13 (electrode formation), electrodes are formed on the wafer by vapor deposition. In step 14 (ion implantation), ions are implanted in the wafer. In step 15 (CMP), the insulating film is planarized, for example by a CMP process. In step 16 (resist process), the wafer is coated with photoresist. In step 17 (exposure), the wafer coated with photoresist is exposed through the mask having the circuit pattern using the above-described exposure apparatus to form latent image patterns in the resist. In step 18 (development), the latent image patterns formed in the resist on the wafer are developed to form resist patterns. In step 19 (etching), a layer or the substrate under the resist patterns is etched through parts where the resist patterns are open. In step 20 (resist stripping), the resist, which is no longer necessary after etching has been completed, is removed. By repeatedly performing these steps, multilayer circuit patterns are formed on the wafer.

The present invention makes it possible, for example, to more reliably perform control of liquid (for example, formation or removal of a liquid film) in the space under the projection optical system during device fabrication.

While the present invention has been described with reference to exemplary embodiments, it is to be understood that the invention is not limited to the disclosed exemplary embodiments. The scope of the following claims is to be accorded the broadest interpretation so as to encompass all modifications, equivalent structures and functions.

## Claims

1. An exposure apparatus for projecting a pattern of an original (1) onto a substrate (9) through a projection optical system (4) and a liquid (f), the exposure apparatus comprising:
liquid supply means (30) adapted to supply liquid to a space between the projection optical system and the substrate;
suction means (50) adapted to suck a fluid in said space;
a fluid sensor (23) operable to detect a change in the kind of fluid being sucked by the suction means,
and control means (19) configured to control the operation of the exposure apparatus in response to the detection by the fluid sensor of a change in the kind of fluid being sucked.

2. The exposure apparatus as claimed in claim 1 in which the control means is configured to change the operating state of the suction means in response to the detection by the fluid sensor of a change in the kind of fluid being sucked.

3. The exposure apparatus according to claim 1 or claim 2, wherein when the space is being filled with the liquid, the control means is configured to stop the suction means from sucking in response to the detection by the fluid sensor of the change of the fluid being sucked by the suction means from gas to liquid.

4. The exposure apparatus according to claim 3, wherein when the space is being filled with the liquid, the control means is configured to stop the suction means sucking a predetermined time after the detection of the change of the fluid being sucked from gas to liquid.

5. The exposure apparatus according to claim 1 or claim 2, wherein when the liquid is being removed from the space, the control means is operable to stop the suction means from sucking in response to the detection of the change of the fluid being sucked by the suction means from liquid to gas.

6. The exposure apparatus according to Claim 5, wherein when the liquid is being removed from the space, the control means is operable to stop the suction means from sucking a predetermined time after the detection by the fluid sensor of the change of the fluid being sucked by the suction unit from liquid to gas.

7. The exposure apparatus according to any preceding claim, further comprising recovery means (40) configured to recover the liquid from the space, and wherein the liquid supply means is configured to supply the liquid and the recovery means is configured to recover the liquid at least during substrate exposure.

8. The exposure apparatus according to Claim 7, wherein the recovery means includes a recovery nozzle (6) disposed around the projection optical system, and the recovery means is operable to recover the liquid through the recovery nozzle from the space.

9. The exposure apparatus according to any preceding claim, wherein the suction means includes a suction port (22) disposed in a stage (10) that holds the substrate, and the suction means is configured to suck the fluid through the suction port from the space between the projection optical system and the substrate.

10. An exposure apparatus according to any preceding claim, further comprising a recovery means configured to recover the liquid through a recovery tube (17) from said space.

11. A device manufacturing method comprising the steps of:
exposing a substrate (9) using the exposure apparatus according to any one of Claims 1 to 10; and
developing the substrate, and
forming a device from the substrate.

12. Use of an exposure apparatus as claimed in any one of claims 1 to 11 in the manufacture of a device.
